# EUROPÄISCHE PATENTANMELDUNG

(11) **EP 2 698 829 A1**
(43) Veröffentlichungstag der Anmeldung: **19.02.2014**
(21) Anmeldenummer: 13179510.6
(22) Anmeldetag: 07.08.2013
(51) Int. Cl.: H01L 31/042, H01L 31/048, C09J 5/06, C09J 7/02, C09J 7/04

(54) **Verfahren zur Herstellung eines Solarmoduls**

(30) Priorität: 13.08.2012 DE 102012214401
(71) Anmelder: tesa AG, 20253 Hamburg (DE)
(72) Erfinder: Schwertfeger, Michael, 22147 Hamburg (DE); Stein, Andreas, 22455 Hamburg (DE)

(57) **Zusammenfassung**

Die Anbringung eines Montagesystems bei der Herstellung eines Solarmoduls soll vereinfacht werden. Dies wird durch ein Verfahren erreicht, das die folgenden Schritte umfasst:
a) Aufeinanderlegen der im Aufbau des Solarmoduls vorgesehenen Schichten, wobei auf die Außenseite der rückseitigen Schicht mindestens ein hitzeaktivierbares doppelseitiges Klebeband und auf dieses mindestens eine Halteplatte aufgelegt wird;
b) Aufeinanderlaminieren der in Schritt a) aufeinandergelegten Schichten zumindest unter dem Einfluss von Wärme.

## Beschreibung

Die vorliegende Erfindung betrifft das technische Gebiet der Solarmodule, wie sie allgemein zur Erzeugung von elektrischer Energie aus Sonnenlicht verwendet werden. Die Erfindung schlägt ein neuartiges Verfahren zur Herstellung von Solarmodulen vor, mit dem insbesondere das Anbringen des Montagesystems vereinfacht wird.

Die Nutzung von Photovoltaik-Anlagen zur Erzeugung von Strom aus regenerativen Energiequellen erfährt eine anhaltende Verbreitung. Photovoltaik-Anlagen bestehen in der Regel aus einer Vielzahl miteinander verschalteter Solarmodule. Diese Module, die auch als Photovoltaikmodule oder kurz als PV-Module bezeichnet werden, enthalten wiederum miteinander verschaltete Solarzellen, in denen die Umwandlung der Energie des Sonnenlichts in elektrische Energie erfolgt.

Solarzellen gibt es in verschiedenen Ausführungsformen, die am häufigsten nach der Materialdicke in Dickschicht- und Dünnschichtzellen unterteilt werden. Am weitesten verbreitet sind Dickschicht-Siliziumzellen entweder als monokristalline Zellen (c-Si) oder multikristalline Zellen (mc-Si). Zunehmend finden jedoch Dünnschichtzellen, häufig auf Basis von amorphem Silizium (a-Si), sowie organische Solarzellen und Farbstoffzellen Verbreitung.

Die Materialien für die am häufigsten eingesetzten Halbleiterzellen umfassen neben den vorstehend schon erwähnten Silizium-Modifikationen insbesondere für Dünnschichtzellen auch Galliumarsenid (GaAs), Cadmiumtellurid (CdTe), Kupfer-Indium-Disulfid (CIS) oder Kupfer-Indium-Gallium-Diselenid (CIGS).

Die Solarzellen werden mit Leiterbahnen an der Vorder- und Rückseite in Reihe geschaltet. Eine bestimmte Anzahl derart miteinander verschalteter Solarzellen bildet dann die Grundlage für ein sogenanntes Solarmodul. Ein solches Solarmodul hat typischerweise folgenden Aufbau:

Die oberste Schicht auf der der Sonne zugewandten Seite wird von einer temperaturbeständigen und schlag-, stoß- und druckfesten Glasscheibe gebildet. Darauf folgt in Richtung auf die sonnenabgewandte Seite eine transparente Kunststoffschicht, die in der Regel aus Ethylenvinylacetat besteht.
Die dritte Schicht bilden dann die miteinander verschalteten Solarzellen.
Die Rückseite des Moduls und somit die äußerste Schicht auf der sonnenabgewandten Seite wird entweder von einer witterungsfesten Kunststofffolie oder von einer weiteren Glasscheibe gebildet. Die dafür eingesetzten Kunststofffolien bestehen häufig aus einem Materialverbund, beispielsweise aus Polyvinylfluorid und Polyester.

Mehrere miteinander verschaltete Solarmodule ergeben einen Solargenerator, der in Kombination mit weiteren Geräten wie zum Beispiel einem Wechselrichter eine Photovoltaikanlage darstellt, die aus Sonnenlicht erzeugten Strom ins Netz einspeisen oder zur direkten Verwendung am Ort der Anlage zur Verfügung stellen kann.

Die Solarmodule werden auf Dächern befestigt oder am Boden aufgeständert. Zu diesem Zweck sind die Module üblicherweise mit Montagesystemen versehen, mittels derer die Verbindung zu den am Einsatzort vorhandenen Aufbauten hergestellt wird.

Generell werden im Produktionsprozess von Solarmodulen das sogenannte "front end" und das sogenannte "back end" unterschieden. Im "front end" wird das Modul mit seinen verschiedenen Schichten durch einfaches Aufeinanderlegen - gegebenenfalls mit Unterstützung durch hilfsweises Fixieren - aufgebaut und anschließend einem Laminationsprozess unterzogen. Dabei schmilzt das Verkapselungsmaterial, bei dem es sich häufig um ein Ethylen-Vinylacetat-Copolymer (EVA) handelt, auf und vernetzt. Die Lamination kann ein- oder mehrstufig verlaufen und vollzieht sich im Wesentlichen unter dem Einfluss der Parameter Druck, Temperatur und Zeit. Mit dem Abschluss des Laminationsprozesses endet das "front end".

Nach dem Durchlaufen des front ends sind die Solarzellen in der transparenten Kunststoffschicht eingebettet und werden von dieser vor Korrosion geschützt.

Im daran anschließenden "back end" werden die Anschlussdose gesetzt, das Modul inspiziert und die Montageprofile aufgeklebt. Das Verkleben des Montagesystems erfolgt üblicherweise mit Selbstklebebändern oder pastösen Klebesystemen. Dieses direkte Aufbringen des Montagesystems auf die Rückseite des Moduls erfolgt insbesondere bei Modulen mit Glasrückseite.

Das Aufbringen von Stütz- beziehungsweise Montageelementen auf die Rückseite eines Solarmoduls wird beispielsweise in WO 2011/109701 A2 beschrieben. Dieser Schrift zufolge wird ein Montageelement ("support member") auf die lichtabgewandte Seite des Solarmoduls mittels einer Kombination aus einem "handling adhesive" und einem Montageklebstoff ("structural adhesive") aufgebracht. Das Montageelement wird dabei von dem handling adhesive solange in seiner Position gehalten, bis der Montageklebstoff vollständig ausgehärtet ist.

Das Verkleben des Montagesystems auf einem Solarmodul erfordert einen eigens dafür eingerichteten, mit speziellen Geräten ausgerüsteten Arbeitsplatz. Der Verklebungsprozess muss sehr exakt durchgeführt werden, um die Qualität sicherzustellen.

Zu den beim Verkleben mittels Selbstklebebändern erforderlichen Materialien gehören beispielsweise Glasreiniger, unterschiedliche Haftvermittler für Glas und Montageprofil sowie ein doppelseitiges Klebeband. Es sind darüber hinaus ein Klebebandabroller und/oder -applikator sowie Geräte zur Profilpositionierung und Profilverpressung nötig. Der Prozess umfasst unter anderem das Reinigen des Montageprofils, das Aufbringen und Abtrocknen des profilseitigen Haftvermittlers, das Aufbringen des Klebebandes, das Reinigen des Glases, das Aufbringen und Abwischen des glasseitigen Haftvermittlers, das Entfernen der Trennfolie vom Montageprofil, das Positionieren des Profils und das - gegebenenfalls maschinell durchgeführte - Andrücken des Profils.

Auch das Verkleben mittels pastöser Klebesysteme erfordert eine umfangreiche apparative Ausstattung, beispielsweise neben dem ein- oder mehrkomponentigen Klebesystem selbst eine spezielle Misch-, Dosier- und Auftragseinheit für das Klebesystem und ein Zwischenlager zum Trocknen des Klebstoffs. Im Prozess wird Zeit für das Antrocknen und die Aushärtung des Klebers benötigt.

Obwohl also beide Prozesse automatisierbar sind, erfordern sie viele Arbeitsschritte, sind apparativ aufwändig und fehleranfällig.

Aufgabe der vorliegenden Erfindung ist es daher, das Aufbringen des Montagesystems eines Solarmoduls zu vereinfachen, ohne dass ein Qualitätsverlust entsteht.

Die Lösung der Aufgabe beruht auf dem Grundgedanken der Erfindung, den Prozessschritt des Verklebens der Teile des Montagesystems, die unmittelbar am Solarmodul haften, bereits im Rahmen des Laminierens im front end durchzuführen. Ein erster Gegenstand der Erfindung ist daher ein Verfahren zur Herstellung eines Solarmoduls, das die folgenden Schritte umfasst:
a) Aufeinanderlegen der im Aufbau des Solarmoduls vorgesehenen Schichten, wobei auf die Außenseite der rückseitigen Schicht des Solarmoduls mindestens ein hitzeaktivierbares doppelseitiges Klebeband und auf dieses mindestens eine Halteplatte aufgelegt wird;
b) Aufeinanderlaminieren der in Schritt a) aufeinandergelegten Schichten zumindest unter dem Einfluss von Wärme.

Das erfindungsgemäße Verfahren ermöglicht vorteilhaft den Wegfall des aufwändigen Verklebens des Montagesystems im back end und stellt somit eine erhebliche Vereinfachung des Herstellungsprozesses von Solarmodulen dar. Das Positionieren der Halteplatte gestaltet sich einfacher und robuster als bei herkömmlichen Verfahren, indem beispielsweise ein Ausquetschen des Klebers vermieden wird, einfachere Zuschnitte der Halteplatte möglich werden und insgesamt eine verbesserte Handhabbarkeit der Geräte erreicht wird. Das Anbringen des Montagesystems wird darüber hinaus zeitlich und räumlich weitgehend in die Herstellung des Moduls integriert, da die Halteplatte(n) bereits während dieses Prozesses verklebt wird (werden). Die Befestigung des eigentlichen Montagesystems kann dann entweder direkt nach der Modulherstellung oder auf der Baustelle in einfacher Weise erfolgen. Zudem besteht durch die Aufteilung in Halteplatte und Montagesystem mehr Freiheit in der Auswahl individueller Montagesysteme.

Unter einem "Solarmodul" wird eine mehrere elektrisch miteinander verschaltete Solarzellen umfassende Vorrichtung verstanden, mit der das Licht der Sonne in elektrische Energie umgewandelt werden kann. Erfindungsgemäß bevorzugt ist das Solarmodul ein Glas-Glas-System, das heißt sowohl die äußerste Schicht auf der sonnenzugewandten als auch die äußerste Schicht auf der sonnenabgewandten Seite werden von einer Glasscheibe gebildet. Derartige Glas-Glas-Module sind bei Solarmodulen aus Dickschichtzellen eine übliche Ausgestaltungsform. Dünnschichtmodule wurden bislang in den meisten Fällen durch Abscheiden des Halbleitermaterials aus der Gasphase auf einen Träger hergestellt. Bei dem Material dieses Trägers kann es sich um Glas, Metall, Kunststoff oder auch ein anderes Material handeln. Basierend auf der Entwicklung dünnerer und preiswerterer Gläser werden zunehmend auch Dünnschicht-Solarmodule als Glas-Glas-Systeme hergestellt.

Unter den "im Aufbau des Solarmoduls vorgesehenen Schichten" werden sämtliche Elemente, Bauteile etc. verstanden, die im Laminierschritt miteinander verbunden werden sollen und somit der Lamination unterzogen werden. Der Begriff "Schicht" umfasst somit auch starre und verhältnismäßig große Bauteile wie Glasscheiben und Halteplatten.

Unter der "rückseitigen Schicht" des Solarmoduls wird die äußerste, auf der sonnenabgewandten Seite befindliche Schicht des Solarmoduls verstanden. Die Außenseite dieser Schicht ist diejenige, welche von den weiteren Schichten des Solarmoduls abgewandt ist und somit in unmittelbarem Kontakt mit dem die Rückseite des Moduls umgebenden Material beziehungsweise mit der die Rückseite des Moduls umgebenden Atmosphäre steht. Erfindungsgemäß bevorzugt ist die rückseitige Schicht eine Glasschicht.

Unter einer "Halteplatte" wird eine Vorrichtung verstanden, die sich auf die Rückseite des Solarmoduls laminieren lässt und die nachfolgende Befestigung eines Montagesystems durch mechanisches Verbinden von Halteplatte und Montagesystem zulässt. Bevorzugt ist die Halteplatte eine Aluminiumplatte. Die Halteplatte sollte insbesondere eine hinreichend flache Geometrie aufweisen, um den Laminationsprozess durchlaufen zu können. Die Dicke der Halteplatte beträgt bevorzugt maximal 20 mm, stärker bevorzugt maximal 15 mm, insbesondere maximal 10 mm. Unter der Dicke der Halteplatte wird dabei die Ausdehnung der Halteplatte vertikal zu der durch die Rückseite des Solarmoduls gebildeten Ebene verstanden.

Beispielsweise kann die Halteplatte eine Aluminiumplatte mit den Abmessungen 150 mm : 150 mm : 5mm sein, die gefasste Kanten aufweist und mit Gewindebohrungen M6 versehen ist, an die das Montagesystem angeschraubt wird. Die Dicke der Halteplatte beträgt in diesem Beispiel 5 mm. Die gefassten Kanten verhindern vorteilhaft eine Beschädigung der empfindlichen Transporttücher im Laminationsprozess.

Bevorzugt umfasst das erfindungsgemäße Verfahren als Schritt c) das Anbringen eines Montagesystems für das Solarmodul durch Befestigen an der Halteplatte.

Das Montagesystem selbst kann beispielsweise Gelenkbolzen umfassen, die gleichzeitig den Krafteintrag durch Wärmeausdehnung vom Montagesystem in das Solarmodul minimieren. Dies ist beispielsweise bei der Einwirkung von Wärme auf die auf dem Dach montierten Solarmodule bedeutsam. Wenn alle Ansatzpunkte fest verschraubt sind und die Materialien sich in der Hitze ausdehnen, wirken starke Kräfte auf das Modul ein. In diesem Fall ist zum Abfangen dieser Kräfte eine Kombination von sogenannten Fest- und Loslagern sinnvoll. Derartige Loslager können von den Gelenkbolzen des Montagesystems gebildet werden.

Um das positionsgenaue Auflegen des Klebesystems und der Halteplatte zu erleichtern, wird vorzugsweise eine Schablone, zum Beispiel in Gestalt eines Rahmens, der auf das Laminat geklappt wird, eingesetzt.

Unter einem "hitzeaktivierbaren Klebeband" wird ein Klebeband auf Basis eines Klebstoffs verstanden, der bei Einbringung thermischer Energie vernetzt wird und dabei eine für die beabsichtigte Verklebung hinreichende Verklebungsfestigkeit (hinreichende Adhäsion, hinreichende Kohäsion) aufbaut. Der Klebstoff beziehungsweise die Klebemasse kann bei Raumtemperatur nicht, schwach oder auch stark anfassklebrig (haftklebrig, tackig) sein. Die Aktivierungstemperaturen für die thermische Vernetzung liegen deutlich über Raumtemperatur, üblicherweise bei mindestens 80 °C oder mehr. Erfindungsgemäß bevorzugte Aktivierungstemperaturen für die thermische Vernetzung, insbesondere um die erforderliche Verklebungsfestigkeit zu garantieren, liegen bei mindestens 90 °C, insbesondere zwischen 95 °C und 120 °C.

Der allgemeine Ausdruck "Klebeband" umfasst im Sinne der Erfindung alle flächigen Gebilde wie in zwei Dimensionen ausgedehnte Folien oder Folienabschnitte, Bänder mit ausgedehnter Länge und begrenzter Breite, Bandabschnitte, Stanzlinge und dergleichen. Es ist erfindungsgemäß auch möglich, mehrere hitzeaktivierbare Klebebänder übereinander zu schichten, um auf diese Weise eine größere Dicke der Verklebungsschicht zu erreichen. Bevorzugt werden zwei Klebebänder übereinander gelegt. Durch die Hitzeaktivierung entsteht ein fester Verbund, der vorteilhaft die Eigenschaften einer dickeren Klebeschicht aufweist.

Bevorzugt umfasst das hitzeaktivierbare Klebeband des Schrittes a) des erfindungsgemäßen Verfahrens eine Klebemasse, die mindestens einen Nitrilkautschuk und mindestens ein Phenolharz enthält. Bevorzugt beträgt der Gesamtgehalt an Nitrilkautschuk in der Klebemasse 30 - 80 Gew.-%, besonders bevorzugt 40 - 70 Gew.-%, bezogen auf das Gesamtgewicht der Klebemasse. Der Gesamtgehalt an Phenolharzen in der Klebemasse beträgt bevorzugt 20 - 70 Gew.-%, besonders bevorzugt 30 - 60 Gew.-%, bezogen auf das Gesamtgewicht der Klebemasse. Insbesondere beträgt das Gewichtsverhältnis der Gesamtmenge an Nitrilkautschuk zur Gesamtmenge an Phenolharzen in der Klebemasse von 1,3:1 bis 0,7:1, ganz besonders bevorzugt von 1,1:1 bis 0,9:1, beispielsweise von 1,05:1 bis 0,95:1.

Unter einem "Nitrilkautschuk" wird ein Polymer verstanden, das durch Copolymerisation von Acrylnitril und Butadien, gegebenenfalls zusätzlich auch von Isopren, erhalten wird. Bevorzugt beträgt der Gewichtsanteil von Acrylnitril an einem derartigen Polymer 15 - 70 Gew.-%, besonders bevorzugt 20 - 60 Gew.-%, insbesondere 30 - 55 Gew.-%. Wie vorstehend bereits beschrieben, sind auch Copolymere aus Acrylnitril-Butadien und Isopren einsetzbar.

Unter "Phenolharzen" werden synthetische Harze verstanden, die durch Kondensation von Phenolen mit Aldehyden, insbesondere mit Formaldehyd, durch Derivatisierung der dabei resultierenden Kondensate oder durch Addition von Phenolen an ungesättigte Verbindungen wie Acetylen, Terpene oder natürliche Harze gewonnen werden. Die Phenolharze können in zwei Gruppen eingeteilt werden: zum einen in die Resole, die bei der Herstellung mit einem Überschuss an Formaldehyd entstehen, und zum anderen in die Novolake, die bei einem Formaldehydunterschuss gebildet werden. Die Resole vernetzen in der Hitze oder durch Säurezugabe spontan mit sich selbst unter Abgabe von Wasser, während die Novolake nur miteinander reagieren, wenn ein Formaldehydspalter als Vernetzer wirkt. Bei ihrer Vernetzung wird kein Wasser abgespalten.

Um die Adhäsion zu erhöhen, ist auch der Zusatz von mit den Elastomeren verträglichen Klebharzen ("Klebrigmachern") zur Klebemasse in vorteilhafter Vorgehensweise möglich.

Als Klebrigmacher können in der Klebemasse des hitzeaktivierbaren Klebebandes zum Beispiel nicht hydrierte, partiell oder vollständig hydrierte Harze auf Basis von Kolophonium und Kolophoniumderivaten, hydrierte Polymerisate des Dicyclopentadiens, nicht hydrierte, partiell, selektiv oder vollständig hydrierte Kohlenwasserstoffharze auf Basis von C₅-, C₅/C₉-oder C₉-Monomerströmen, Polyterpenharze auf Basis von α-Pinen und/oder ß-Pinen und/oder δ-Limonen, hydrierte Polymerisate von bevorzugt reinen C₈-und C₉-Aromaten eingesetzt werden. Die vorgenannten Klebharze können sowohl allein als auch im Gemisch eingesetzt werden. Klebrigmacher können vorteilhaft in einem Anteil von bis zu 20 Gew.-%, bezogen auf die abgemischte Klebemasse, in dieser enthalten sein.

Es können auch geringe Mengen an Epoxidharzen eingesetzt werden. Um die Lagerstabilität zu erhalten, übersteigt bevorzugt die Menge an Epoxidharz 10 Gew.-% nicht.

Unter "Epoxidharzen" werden sowohl monomere als auch oligomere Verbindungen mit mehr als einer Epoxidgruppe pro Molekül verstanden. Dies können Reaktionsprodukte von Glycidestern oder Epichlorhydrin mit Bisphenol A oder Bisphenol F oder Mischungen aus diesen beiden sein. Einsetzbar sind ebenfalls Epoxidnovolakharze, gewonnen durch Reaktion von Epichlorhydrin mit dem Reaktionsprodukt aus Phenolen und Formaldehyd. Auch monomere Verbindungen mit mehreren Epoxidendgruppen, die als Verdünner für Epoxidharze eingesetzt werden, sind verwendbar. Ebenfalls sind elastisch modifizierte Epoxidharze einsetzbar.

Als weitere Additive können optional genutzt werden:
- primäre Antioxidanzien wie zum Beispiel sterisch gehinderte Phenole;
- sekundäre Antioxidanzien wie zum Beispiel Phosphite oder Thioether;
- weitere Alterungsschutzmittel wie sterisch gehinderte Amine;
- Prozessstabilisatoren wie zum Beispiel C-Radikalfänger;
- Lichtschutzmittel wie zum Beispiel UV-Absorber;
- Verarbeitungshilfsmittel;
- Füllstoffe, zum Beispiel Siliziumdioxid, Glas (gemahlen oder in Form von Kugeln), Aluminiumoxide, Zinkoxide, Titandioxide, Ruße, Metallpulver, etc.;
- Farbpigmente und Farbstoffe sowie optische Aufheller;
- gegebenenfalls weitere Polymere von bevorzugt elastomerer Natur.

Die vorgenannten und gegebenenfalls weitere Additive können allein oder in Kombination miteinander eingesetzt werden.

Die Klebemasse kann auch einen oder mehrere Weichmacher enthalten. Durch den Einsatz von Weichmachern kann die Elastizität der vernetzten Klebmasse erhöht werden. Als Weichmacher können dabei zum Beispiel niedermolekulare Polyisoprene, Polybutadiene, Polyisobutylene oder Polyethylenglykole und/oder Polypropylenglykole eingesetzt werden.

Zur Herstellung des Klebebandes werden die Bestandteile der Klebemasse insbesondere in einem geeigneten Lösungsmittel, zum Beispiel Butanon, gelöst oder suspendiert, auf ein flexibles Substrat, das mit einer Releaseschicht versehen ist (zum Beispiel ein Trennpapier oder eine Trennfolie), beschichtet und getrocknet, so dass die Masse von dem Substrat leicht wieder entfernt werden kann. Nach entsprechender Konfektionierung können Stanzlinge, Rollen oder sonstige Formkörper bei Raumtemperatur hergestellt werden.

Die erfindungsgemäß verwendeten hitzeaktivierbaren Klebebänder können mit einem Abdeckmaterial (Releaseliner; Liner) versehen sein, etwa mit silikonisiertem Papier, silikonisierter Polymerfolie (beispielsweise silikionisierter PET-Folie) oder dergleichen.

Erfindungsgemäß ist es möglich, die durch das hitzeaktivierbare Klebeband beziehungsweise die hitzeaktivierbaren Klebebänder zu verbindenden Flächen vorzubehandeln. Eine derartige Vorbehandlung umfasst sowohl physikalische als auch chemische Methoden. Insbesondere kann die Außenseite der rückseitigen Schicht des Solarmoduls mit einem Primer versehen werden, beispielsweise mit einem Primer für Glas. Das im Rahmen des erfindungsgemäßen Verfahrens vorgesehene "Auflegen mindestens eines hitzeaktivierbaren doppelseitigen Klebebandes auf die Außenseite der rückseitigen Schicht des Solarmoduls" umfasst ausdrücklich auch das Auflegen des Klebebandes auf eine mittels Primer vorbehandelte Außenseite der rückseitigen Schicht des Solarmoduls. Sofern die rückseitige Schicht des Solarmoduls eine Glasscheibe beziehungsweise eine Glasschicht ist, wird darunter auch eine mit Primer behandelte Glasscheibe beziehungsweise eine mit Primer behandelte Glasschicht verstanden.

Ein weiterer Gegenstand der Erfindung ist ein Solarmodul, das nach dem erfindungsgemäßen Verfahren erhältlich ist.

Ein weiterer Gegenstand der Erfindung ist die Verwendung eines hitzeaktivierbaren doppelseitigen Klebebandes in Laminierverfahren zur Herstellung von Solarmodulen. Bevorzugt wird das hitzeaktivierbare doppelseitige Klebeband zum Anbringen einer Halteplatte für ein Montagesystem verwendet.

### Beispiele

Es wurden Testkörper durch Verklebung von Aluminiumplatten auf Glasscheiben mittels eines hitzeaktivierbaren Klebebandes hergestellt. Dabei kamen folgende Materialien zum Einsatz:
- Glasscheiben: Einscheiben-Sicherheitsglas 19,5 x 37 cm mit einer Dicke von 3 mm beziehungsweise 2,5 x 10 cm mit einer Dicke von 6 mm
- Aluminiumplatten: Aluminiumstreifen 7,5 x 2,5 cm mit einer Dicke von 3 mm
- Klebeband: tesa^{®} HAF 8402; tesa^{®} HAF 8400

Die Klebebänder wurden dabei einlagig (ein Klebeband) oder doppellagig (zwei aufeinandergelegte Klebebänder) verwendet.

Es wurden Testmuster mit einer Verklebungsfläche von jeweils 2,5 x 2,5 cm durch Aufeinanderlegen der Glasscheibe, des Klebebandes/der Klebebänder und der Aluminiumplatte und anschließendes Aufeinanderlaminieren bei 150°C und 1 bar über 90 s hergestellt. Diese Laminationsparameter entsprechen üblichen Bedingungen bei der Herstellung von Solarmodulen.

Anschließend wurden die Muster gemäß der in der Solarindustrie bekannten Feuchte-Frost-Prüfung entsprechend EN 61215:2005 konditioniert. Bei der Feuchte-Frost-Prüfung werden die Testkörper zunächst von Raumtemperatur auf 85°C erhitzt und 20 h bei 85 % relativer Luftfeuchte auf dieser Temperatur gehalten. Anschließend wird auf -40°C abgekühlt (nach Erreichen der Raumtemperatur ohne Regulierung der Luftfeuchte), und der Testkörper wird für mindestens 30 min bei dieser Temperatur gelagert. Danach wird wieder bis auf 85°C aufgeheizt (ab Erreichen der Raumtemperatur wieder bei 85 % relativer Luftfeuchte), und der Zyklus wird erneut durchlaufen. Vom Beginn des Abkühlens bis zum erneuten Erreichen der 85°C dürfen maximal 4 h vergehen. Insgesamt sieht die Prüfung ein zehnmaliges Durchlaufen des Zyklus vor.

Zur Untersuchung der Verklebungsfestigkeit wurden die Proben nach dem Konditionieren einem dynamischen Schertest an einer Zwick-Zugprüfmaschine unterzogen. Dabei wurden die Testkörper mit einer Geschwindigkeit von 10 mm/min in y-Richtung auseinander gezogen und die dabei gemessene Maximalkraft als Ergebnis angegeben. Die Testergebnisse sind in Tabelle 1 dargestellt.

**Tabelle 1: Testergebnisse**

| Nr. | Glasdicke | Klebeband | Festigkeit (N/cm²) | Bruchbild |
|---|---|---|---|---|
| 1 | 3 mm | tesa^{®} HAF 8400 einlagig | 1114 | Glasbruch |
| 2 | 3 mm | tesa^{®} HAF 8400 doppellagig | 1170 | Aluminiumbruch |
| 3 | 6 mm | tesa^{®} HAF 8402 einlagig | 1118 | Glasbruch |
| 4 | 6 mm | tesa^{®} HAF 8400 einlagig | 994 | Glasbruch |
| 5 | 6 mm | tesa^{®} HAF 8400 doppellagig | 861 | Glasbruch |

Wie die Testergebnisse zeigen, werden mit hitzeaktivierbaren Klebebändern hervorragende Scherfestigkeiten bei Verklebungen von Materialien, wie sie üblicherweise für Solarmodule verwendet werden, unter in der Solarmodulproduktion üblichen Bedingungen erreicht. Die verfahrenstechnischen Vorteile der erfindungsgemäßen Methode stehen somit der vorgesehenen Anwendung zur Verfügung.

## Patentansprüche

1. Verfahren zur Herstellung eines Solarmoduls, umfassend die folgenden Schritte:
a) Aufeinanderlegen der im Aufbau des Solarmoduls vorgesehenen Schichten, wobei auf die Außenseite der rückseitigen Schicht mindestens ein hitzeaktivierbares doppelseitiges Klebeband und auf dieses mindestens eine Halteplatte aufgelegt wird;
b) Aufeinanderlaminieren der in Schritt a) aufeinandergelegten Schichten zumindest unter dem Einfluss von Wärme.

2. Verfahren gemäß Anspruch 1, **dadurch gekennzeichnet, dass** die rückseitige Schicht eine Glasschicht ist.

3. Verfahren gemäß mindestens einem der vorstehenden Ansprüche, **dadurch gekennzeichnet, dass** das Solarmodul ein Glas-Glas-System ist.

4. Verfahren gemäß mindestens einem der vorstehenden Ansprüche, **dadurch gekennzeichnet, dass** das hitzeaktivierbare Klebeband eine Klebemasse umfasst, die mindestens einen Nitrilkautschuk und mindestens ein Phenolharz umfasst.

5. Solarmodul, erhältlich durch ein Verfahren gemäß mindestens einem der vorstehenden Ansprüche.

6. Verwendung eines hitzeaktivierbaren doppelseitigen Klebebandes in Laminierverfahren zur Herstellung von Solarmodulen.

7. Verwendung gemäß Anspruch 6, **dadurch gekennzeichnet, dass** das hitzeaktivierbare doppelseitige Klebeband zum Anbringen einer Halteplatte für ein Montagesystem verwendet wird.
